# EUROPEAN PATENT APPLICATION

(11) **EP 1 202 346 A1**
(43) Date of publication of application: **02.05.2002**
(21) Application number: 00308596.6
(22) Date of filing: 29.09.2000
(51) Int. Cl.: H01L 23/467

(54) **Heat sink arrangement**

(71) Applicant: SIEMENS AKTIENGESELLSCHAFT, 80333 München (DE)
(72) Inventor: Taylor, Russell, Manchester M14 5DN (GB); Grindon, Adrian, Congleton CW12 4JY (GB)
(74) Representative: Allen, Derek

(57) **Abstract**

A heat sink arrangement (200) for cooling a device irrespective of the orientation of the device, the heat sink arrangement (200) including a base portion (204) and a plurality of fins (202) arranged at substantially right angles to the base portion (204). Each of the fins (202) has at least a portion which directs ambient airflow across the cooled device. Rather than providing fragile pin fingers or forcing air across the cooled device, the heat sink arrangement (200) constitutes a passive and rugged cooling arrangement which can be oriented in any position, except inverted, and still allow cooling airflow across the cooled device.

## Description

The present invention relates to a heat sink arrangement. In particular the invention relates to a heat sink arrangement which allows adequate convection cooling to be achieved when the equipment for which it is provided is in any orientation except a fully inverted orientation.

Electrical devices, for example frequency inverters, often produce a large amount of heat in operation yet this heat itself can impair future operation of the device if it is not carried away by radiation, convection and/or conduction. Since electrical equipment is often required to be capable of being installed in a number of different orientations, it is advantageous if a heat sink can be provided which can convey heat away from the neighbourhood of the electrical equipment regardless of the orientation.

A pin finger heat sink arrangement is currently used to solve this problem. Any surface from which heat is to be dissipated is provided with a base portion from which a plurality of long, thin pin fingers extends. Each pin finger extends to a predetermined height, hₚ, above the base portion. The projection of each pin onto the plane of the base portion defines a simple two dimensional shape, for example a circle, of radius rₚ, or a square of side, b. Characteristically, the height, hₚ, of each pin is much greater than the characteristic dimension of the two dimensional shape, for example rₚ or b.

For ease of manufacture, the heat sink is generally diecast with a base portion and with cylindrical pin fingers. The cylindrical pin fingers have uniform height, hₚ, uniform radius, rₚ, and are arranged in a square or rectangular grid having a characteristic spacing, aₚ, between neighbouring pin fingers. Pin finger heat sink arrangements do however have their disadvantages: they are difficult to keep clean and slender pin fingers can also be susceptible to mechanical damage. As will be easily comprehended, a pin finger is particularly prone to damage when a physical force with a component in the plane of the base portion is applied.

An common alternative approach requires the presence of a forced cooling device, for example a cooling fan. By compelling the circulation of air over a piece of equipment needing cooling, this approach allows cooling of equipment irrespective of the orientation of that equipment. The forced cooling approach has drawbacks too: in many implementations the expense of provision of and reliance upon the presence of the forced cooling device is unacceptable.

Naturally a combination of forced cooling and heat sink arrangement is possible. Rather than cancelling out, the problems associated with the two solutions tend to accumulate.

It is therefore an object of the invention to obviate or at least mitigate the aforementioned problems.

In accordance with one aspect of the present invention, there is provided a heat sink arrangement for cooling a device irrespective of the orientation of the device, the heat sink arrangement including a base portion and a radiating portion, which directs ambient airflow across the device irrespective of how the device is oriented; characterised in that the radiating portion comprises a plurality of fins extending from the base portion arranged to intercept airflow from any direction, each of the plurality of fins having a longitudinal extent, L, and a transverse extent, T, the longitudinal extent being greater than the transverse extent.

Fins like pin fingers have a predetermined height, h. However, the projection of a fin onto the base portion is a two dimensional shape with a longitudinal extent and a transverse extent. The characteristic length of the longitudinal extent is of a similar order of magnitude to the height, h, while the characteristic length of the transverse extent is much smaller than the height, h.

Preferably, each of the plurality of fins extends to a predetermined height above the base portion.

Alternatively, the plurality of fins comprises at least one first fin and at least one second fin, each first fin extending to a first predetermined height, h₁, above the base portion and each second fin extending to a second predetermined height, h₂, above the base portion, the first predetermined height, h₁, being greater than the second predetermined height, h₂.

Advantageously, at least one of the plurality of fins is curved.

The fins preferably extend from the base portion at substantially right angles.

The finned heat sink arrangement allows convection over the fins irrespective of the orientation (except upside-down).

For a better understanding of the present invention, reference will now be made, by way of example only, to the accompanying drawings in which:-
Figure 1 shows a known pin finger heat sink arrangement;
Figure 2 shows a finned heat sink arrangement in accordance with the present invention;
Figure 3 shows a cross-section through a portion of a finned heat sink arrangement in accordance with the present invention; and
Figure 4 shows a cross-section through a portion of an alternative finned heat sink arrangement in accordance with the present invention.

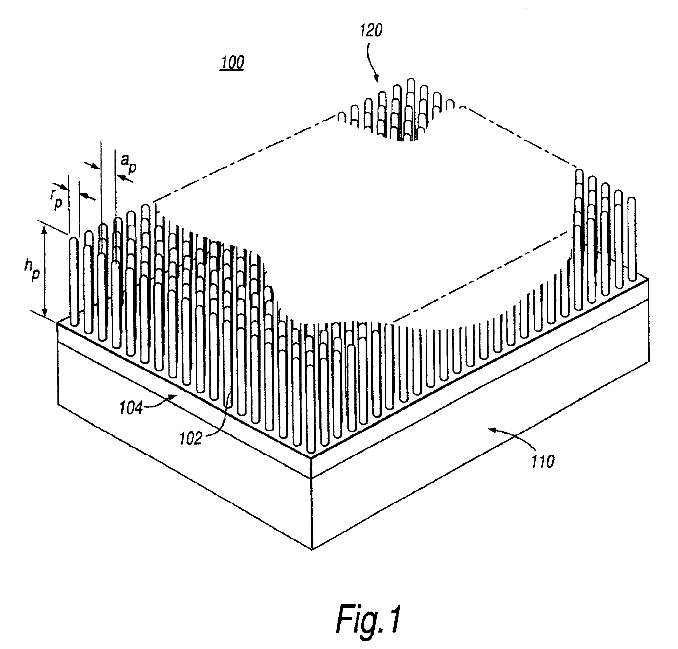

The known pin finger heat sink arrangement 100 shown in Figure 1 is disposed adjacent to a piece of equipment 110 which requires improved heat dispersion, for example a power converter. Each pin finger 102 presents a radiating surface area across which moving air can circulate thus dissipating excess heat generated by the equipment 110. The heat sink arrangement 100 shown in Figure 1 is diecast with a base portion 104 and with cylindrical pin fingers 102. The cylindrical pin fingers 102 have uniform height, hₚ, uniform radius, rₚ, and are arranged in a square grid having a characteristic spacing, aₚ, between neighbouring pin fingers 102. It will be noted that the height, hₚ, of each pin finger 102 is much greater than the radius rₚ of the circle projected by the pin finger onto the base portion 104.

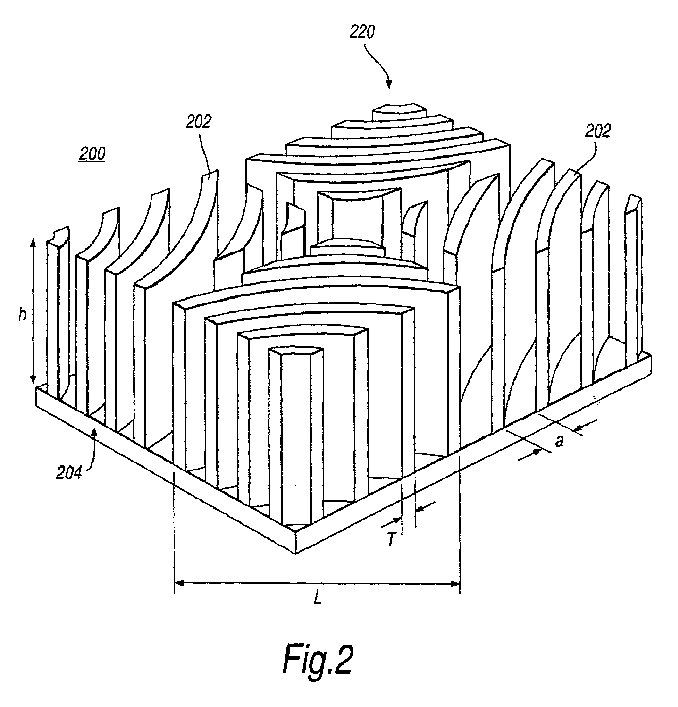

A heat sink arrangement 200 in accordance with the present invention is shown in Figure 2. Here, the heat sink arrangement 200 includes a base portion 204 and a plurality of fins 202 arranged in four distinct symmetrical quadrants. Each of the fins 202 is a solid wall of known height, h, relative to the base portion 204. To form a wall, each fin 202 has a longitudinal extent having a length of the same order of magnitude as the height, h, and deflects at least some of the air flowing across the fin. Typically, the value of h is between 15mm and 45mm. The fins 202 are thus able to provide convection cooling irrespective of the heat sink orientation (except upside-down). The finned heat sink arrangement 200 is also more robust than the pin finger heat sink arrangement 100 of Figure 1. As discussed previously, excess force with a component in the plane of the base portion will cause pin fingers 102 to shear whilst fins 202, with their longitudinal extent are likely to be more resistant to shear forces.

The heat sink arrangement 200 is diecast in aluminium and painted black to enhance the dissipation of heat therefrom.

In the above embodiment, the fins 202 are curved, evenly spaced and arranged in symmetrical quadrants to deflect airflow from any direction. It will be understood however that the fins 202 may take many alternative arrangements without impairing their functionality, for example:
a) the quadrants need not be arranged symmetrically; an asymmetrical arrangement of fins 202 would be considered if airflow could be guaranteed from a limited range of directions;
b) the fins 202 themselves need not be curved in shape, straight fins and fins having sharp vertices are also possible;
c) the fins are not restricted having a uniform separation, a, indeed closer spacings may be desirable either to enhance robustness in a particular portion of the heat sink arrangement or to create a desirable airflow profile; and
d) different fins may have different heights to encourage cooling under different airflow conditions.

It should also be noted that the above alternative arrangements may also be implemented in combination.

A typical value for the spacing, a, is 3mm, and with a height, h, of 42mm, a ratio of height to spacing of 14 is obtained. Naturally, over the range of values for h mentioned above, the ratio of height to spacing, for a spacing of 3mm, will lie between 5 and 15.

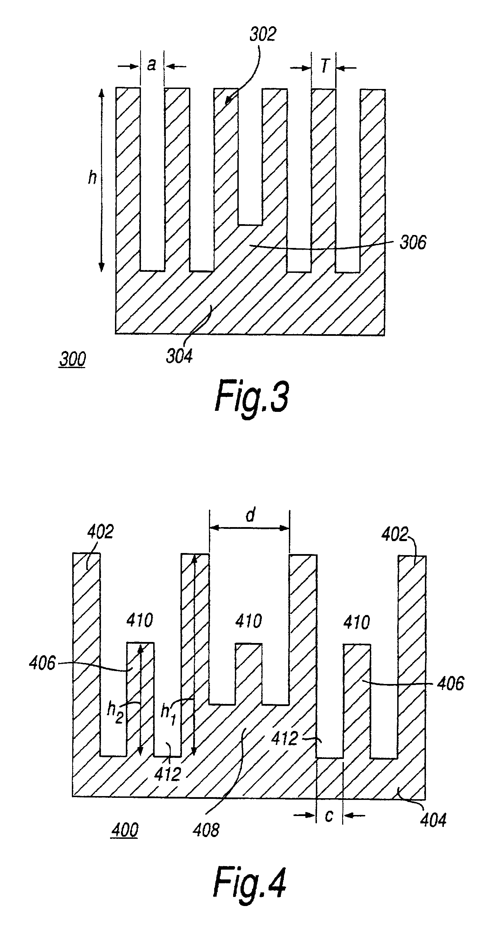

The cross-section shown in Figure 3, is a section across a finned heat sink arrangement 300 with fins of a predetermined height, h and even spacing, a. In addition to the provision of fins 302 and a base portion 304, there is a heat spreader 306 which serves to further facilitate the dissipation of heat from equipment adjacent to it. Heat spreaders 306 may be provided in many positions upon the base portion 304 in accordance with the heat dissipation requirements of the equipment.

Figure 4 shows a cross-section through an alternative finned heat sink arrangement 400. The alternative finned heat sink arrangement 400 includes a base portion 404, a plurality of fins 402,406 and a heat spreader 408. Here the plurality of fins are provided in two heights, tall fins 402 of height h₁ and short fins 406 of height h₂. A typical value for the ration of the heights, h₁:h₂ would be 2:1. By interleaving tall fins 402 and short fins 406, the alternative arrangement 400 improves the efficiency of cooling under different airflow conditions. Faster flowing air tends not to penetrate the spaces between short and tall fins 412 preferring rather to flow in the spaces between tall fins 410. Slower flowing air does penetrate into the spaces between short and tall fins 412 and thus provides more effective surface area to slower flowing air.

The spacing, d, between neighbouring tall fins 402 is shown as equal in Figure 4 as is the spacing, c, between each tall fin 402 and each neighbouring short fin 406. Typically, c and d have values between 2mm and 5mm with a typical ratio of c:d of 2:1. A height to space ratio of 13:1 can also be typical. As will be clear from the preceding discussion, fins are not necessarily equally spaced: spacing may be varied to enhance the dissipation of heat in certain portions of the heat sink arrangement and to increase robustness around more fragile portions of the heat sink.

## Claims

1. A heat sink arrangement (200;300;400) for cooling a device irrespective of the orientation of the device, the heat sink arrangement (200;300;400) including a base portion (204;304;404) and a radiating portion (220) which directs ambient airflow across the device irrespective of how the device is oriented;
**characterised in that** the radiating portion (220) comprises a plurality of fins (202;302;402,406) extending from the base portion (204;304;404) arranged to intercept airflow from any direction, each of the plurality of fins (202;302;402,406) having a longitudinal extent (L) and a transverse extent (T), the longitudinal extent (L) being greater than the transverse extent (T).

2. A heat sink arrangement (200;300) according to Claim 1, wherein each of the plurality of fins (202;302) extends to a predetermined height (h) above the base portion (204;304).

3. A heat sink arrangement (400) according to Claim 1, wherein the plurality of fins comprises a set of first fins (402) and a set of second fins (406), each first fin (402) extending to a first predetermined height (h₁) above the base portion and each second fin (406) extending to a second predetermined height (h₂) above the base portion (404), the first predetermined height (h₁) being greater than the second predetermined height (h₂).

4. A heat sink arrangement according to Claims 1, 2 or 3, wherein at least one of the plurality of fins (202;302;402,406) is curved.

5. A heat sink arrangement according to any one of the preceding claims, wherein each of the plurality of fins (202;302;402,406) extend from the base portion (204;304;404) at substantially right angles.
